# EUROPEAN PATENT SPECIFICATION

(11) **EP 0 958 609 B1**
(45) Date of publication and mention of the grant of the patent: **16.11.2011**
(21) Application number: 97915795.5
(22) Date of filing: 18.03.1997
(51) Int. Cl.: H01L 29/24, H01L 29/72, H01L 29/74, H01L 29/78, H01L 21/20

(54) **A FIELD CONTROLLED SEMICONDUCTOR DEVICE OF SiC AND A METHOD FOR PRODUCTION THEREOF**
FELDGESTEUERTE HALBLEITERANORDNUNG AUS SiC UND VERFAHREN ZU DEREN HERSTELLUNG
DISPOSITIF A SEMI-CONDUCTEUR A EFFET DE CHAMP EN SiC ET SON PROCEDE DE FABRICATION

(30) Priority: 27.03.1996 SE 9601178
(43) Date of publication of application: 24.11.1999
(73) Proprietor: CREE, INC., Durham, NC 27703 (US)
(72) Inventor: HARRIS, Christopher, S-191 72 Sollentuna (SE); BAKOWSKI, Mietek, S-730 50 Skultuna (SE); GUSTAFSSON, Ulf, S-582 61 Linköping (SE); ANDERSSON, Mats, S-444 53 Stenungsund (SE)
(74) Representative: Wraige, David Leslie Charles
(86) International application number: PCT/SE1997/000448
(87) International publication number: WO 1997/036313

(56) References cited:
- EP-A1- 0 792 523
- JP-A- 05 259 443
- US-A- 4 454 523
- US-A- 5 323 040
- US-A- 5 396 087

## Description

### TECHNICAL FIELD OF THE INVENTION AND PRIOR ART

The present invention relates to a field controlled semiconductor device of SiC according to the preamble of claim 1 as well as a method for production thereof.

All type of field controlled semiconductor devices are comprised, such as for example field controlled transistors and field controlled thyristors.

Such semiconductor devices of SiC may especially be used as switching devices in power applications owing to the possibilly to turn them on and off very rapidly. Such devices made of SiC are particularly well suited for high power applications, since such applications make it possible to benefit from the superior properties of SiC in comparison with especially Si, namely the capability of SiC to function well under extreme conditions. SiC has a high thermal stability due to a large bandgap energy, such that devices fabricated from said material are able to operate at high temperatures, namely up to 1000K. Furthermore, it has a high thermal conductivity, so that SiC devices may be arranged at a high density. SiC also has a more than five times higher breakdown field than Si, so that it is well suited as a material in high power devices operating under condition where height voltages may occur in the blocking state of a device.

Such field controlled semiconductor devices may be divided into two main groups, namely so called normally-off devices and normally-on devices, which means that said channel region layer will have no conducting channel allowing an electron transport from the source region layer to the drift layer when the gate electrode is laid on a zero potential and that such a conducing channel is there when the gate electrode is laid on zero potential, respectively. Normally-off devices are more interesting and have more applications, since no voltage has to be applied to the gate electrode for cutting the electron transport of the device off, but the present invention covers both types of devices.

A field controlled semiconductor device of the type defined in the introduction is known through the US patent 5 323 040 and this device has vertical channel regions, which are laterally restricted by trenches receiving a gate electrode. The channel region layer has to be very thin, in the order of a couple of µm, for creating a normally-off device. The trenches in this known device has to be created by etching, and it is very delicate to etch for obtaining such thin layers, so that it will be difficult and complicated to give a device constructed in that way a normally-off characteristic.

A device according to the introduction is known through JP-A-05259443. Although a normally-off-device may be created by using the design shown therein or that shown in US-A-5396087, it is desired to improving the possibilities to obtain different behaviours of a device of this type related to the ability to control the conducting through a channel between the source region layer and the drift layer.

### SUMMARY OF THE INVENTION

It is an object of the present invention to provide a field controlled semiconductor device of SiC of said type making it possible to at least partially satisfy this desire and a method for producing such a field controlled semiconductor device.

This object is according to the invention obtained by providing a field controlled semiconductor device and a method according to appended claims 1 and 8, respectively.

The dependent claims ses out particular embodiments of the invention.

According to a preferred embodiment of the invention said p-type base layer is highly doped. This will facilitate the realisation of a normally-off device and will also make it easier to turn a normally-on device off by depleting the entire cross-section area of said channel region layer between the base layer and the upper surface of the channel region layer. Furthermore, the device may thanks to this characteristic be able to take higher voltages.

According to another preferred embodiment of the invention said gate electrode is insulated with respect to the channel region layer by an interposed insulating layer. This will make it possible to fabricate a field controlled semiconductor device of SiC having an insulated gate, but in which the conducting channel is not created at the interface between the insulating layer and the semiconductor layer, where the trap density is comparatively high, but at a distance therefrom in the bulk.

According to another preferred embodiment of the invention the thickness and doping concentration of the low doped channel region layer are co-ordinated with the doping concentration of the base layer and the choice of the gate so as to form a p-type depletion region in the channel region layer totally blocking the passage of electrons from said source region layer to the drift layer when a zero potential is laid on the gate electrode for making the device a normally-off device. A device having this preferred characteristic may in this way easily be realised, essentially through the lateral extension of the channel region layer and the possibility to form it by epitaxial growth.

According to another preferred embodiment of the invention said device is a MISFET having a highly doped n-type substrate layer, said low doped n-type channel region layer is a part of the drift layer extending laterally in between the insulating layer and said base layer, which is buried in the drift layer, for forming, upon applying a voltage to said gate electrode, a conducting channel from the source region layer to the drift layer at the interface between the base layer and said channel region layer at a distance from said insulating layer. In this way the acceptor like traps formed through the injection of the electrons from the SiC into the insulating layer of conventional MISFETS having a conducting inversion channel at the interface between the SiC layer and the insulating layer will no longer be created, since the conducting channel is in this device formed in the bulk of the material, so that the channel will have a bulk carrier mobility rather than the degraded mobility of the interface channel, so that a lower on-state resistance is obtained. That the insulating layer is removed from the channel makes degradation of the insulating layer due to injected charge largely neglectable.

According to other preferred embodiments of the invention said device is a transistor and a thyristor, respectively, so that field controlled semiconductor devices of SiC of these two types having advantageous features, especially low on-state losses and a normally-off characteristic when desired, may be provided, which will be of interest in different types of high power applications.

According to the invention said device comprises an additional highly doped n-type layer arranged to connect said low doped n-type channel region layer to the drift layer. Such a highly doped additional layer will contribute to reduce the on-state losses of such a device.

According to the invention the source region layer and said additional n-type layer are arranged at a mutual lateral distance leaving a part of said channel region layer exposed to a voltage of said gate electrode therebetween. It will in this way be easy to regulate the cross-section area of the conducting channel between the source region layer and said additional n-type layer and if desired cut it totally off by varying the voltage applied to the gate electrode.

Further object of the invention is to provide a method for producing a field controlled semiconductor device of SiC being one of a) a transistor and b) a thyristor, for which the drawback of the prior art device of this type discussed above is considerably reduced.

Such a method is according to the invention defined in claim 8.

Further advantages and preferred features of the invention will appear from the description and the other claims.

### BRIEF_DESCRIPTION OF THE DRAWINGS

With reference to the appended drawings, below follows a specific description of a preferred embodiment of the invention cited as an example.

In the drawings:
- Fig. 1-4: are schematic cross-section views illustrating different steps of a method for producing a field controlled transistor according to Fig. 4, and
- Fig. 5: is an enlarged cross-section view of primarily the channel region layer of the transistor in Fig. 4, which illustrates how the cross-section area of the conducting channel may be varied_{.}

### DETAILED DESCRIPTION OF PREFERRED EMBODIMENTS OF THE INVENTION

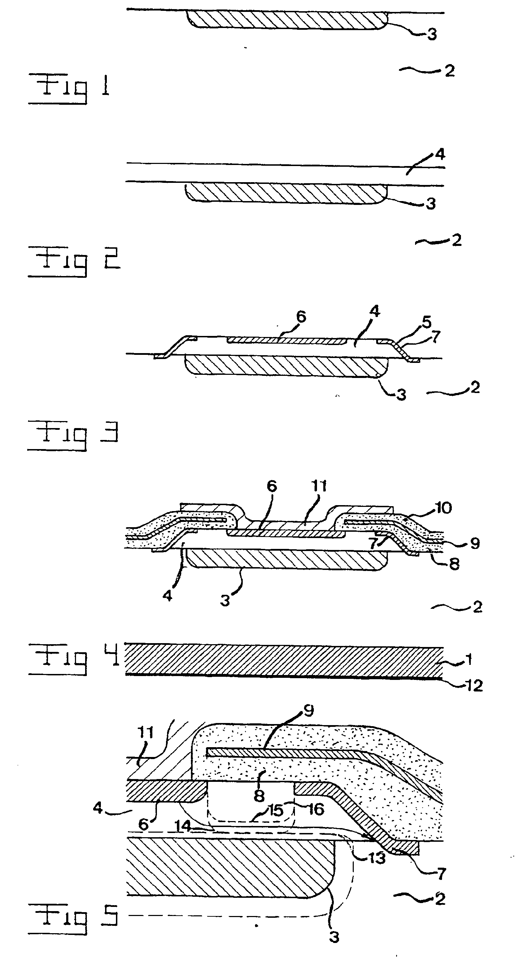

A method for producing a field controlled transistor having a channel region layer with a substantial lateral extension will now be described with reference to Fig. 1-4. Conventional semiconductor device producing steps having nothing to do with the invention, such as masking, demasking and so on, have for the sake of clearness not been shown in the figures. First of all a highly doped n-type substrate layer 1 and on top thereof a low doped n-type drift layer 2 are epitaxially grown (see Fig. 4). After that p-type dopants, preferably aluminium or boron, are implanted into the surface layer of said drift layer for forming a highly doped p-type base layer 3. That step is followed by a step of epitaxial growth (see Fig. 2) of a low doped n-type channel region layer 4 on top of said base layer. This channel region layer 4 has preferably a very low doping concentration, so that it may easily be depleted for forming a blocking depletion layer therein, which will be described further below. This epitaxial growth is preferably carried out by using the Chemical Vapour Deposition technique involving a high temperature, preferably above 1500°C, and an annealing of the implanted layer 3 may be carried out in connection thereto by raising the temperature to 1700°C or more for making the dopants implanted electrically active. After that a MESA-etch is carried out in said channel region layer 4 for forming a wall 5 extending to the drift layer 2. Then are n-type dopants implanted into the surface layer of said channel region layer 4 for forming a highly doped n-type source region layer 6 and n-type dopants are implanted into the channel region layer 4 at a lateral distance from the source region layer and in connection with said wall and into said wall and into a surface layer of the drift layer for forming an additional n-type highly doped layer 7 extending from the surface of the channel region layer 4 to the drift layer 2.

This step is necessarily followed by an annealing step for making said n-type dopants implanted electrically active. The implantation for forming the source region layer 6 may as an alternative be carried out separately before the etching step.

An insulating layer 8, for instance of SiO₂, with a gate electrode 9 thereon is applied on the channel region layer with an extension between the source region layer and the additional n-type layer. Said gate electrode is preferably of poly-crystalline silicon. After that a passivating additional insulating layer 10 is applied over the gate electrode and the upper surface of the device leaving an area of said source region layer 6 exposed and a source 11 is then applied on the layer 6. Finally, a drain contact 12 is applied to the substrate layer 1.

The function of this field controlled transistor will now be described with reference made to Fig. 5. This transistor may be of normally-off as well as normally-on type. We do now assume that it is of the normally-off type, which may be achieved by appropriately choosing the thickness and doping concentration of the channel region layer 4, the gate electrode material and the doping concentration of said base layer 3. A lower doping concentration of the channel region layer 4 and a higher doping concentration of the base layer 3 as well as an appropriate choice of the gate electrode material will make it possible to increase the thickness of the channel region layer and still obtain a normally-off device. The gate electrode 9 will deplete the channel region layer located thereunder according to a dashed line having the lower extension 14 when a zero potential is laid on the gate electrode 9 and the base layer 3 from below according to the dashed line 13, so that a depleted layer 16 is formed between the source region layer 6 and the additional n-type layer 7 blocking an electron transport from the source region layer to the drift layer. Application of a positive voltage to the gate electrode 9 will move the lower extension 14 of the layer depleted by the gate electrode upwardly, and the extension 15 corresponds to a certain level of the voltage applied on the gate electrode 9. In this way a lateral conducting n-type channel 17 is created between the source region layer 6 and the layer 7, and this conducting channel is located at a considerable distance from the upper surface of the channel region layer 4 resulting in a channel mobility equaling bulk mobility due to the channel conduction being independent of the surface conditions, so that the on-state losses of such a device will be very low with respect to for instance a conventional MISFET. Thanks to the possibility to create a channel region layer 4 by epitaxial growth, which may be realised by conventional techniques thanks to the lateral extension thereof, this may be made arbitrarily thick, which means that it may be easily made very thin for the production of a normally-off device. Such a device may of course also be made as a normally-on device, so that a voltage of an opposite sign to that according to above has to be applied to the gate electrode for eliminating the conducting channel 17.

The invention is of course not in any way restricted to the preferred embodiment described above, but many possibilities to modifications thereof will be apparent for a man skilled in the art without departing from the basic idea of the invention.

It is emphasised that the thicknesses of different layers in the figures can not be interpreted as limiting the scope of the protection, but any thickness relations are intended to be covered by the claims.

The dopants used may be of any material suitable as dopants for this application.

The number of layers mentioned in the claims is a minimum number, and it is within the scope of the invention to arrange further layers in the devices or dividing any layer into several layers by selective doping of different regions thereof. Especially the drift layer may be composed by sublayers of different doping concentration, such as particularly low doping concentration close to the base layer.

Although it has been shown in the figures that the gate electrode is insulated, the invention is not restricted thereto, but it may also be diffused, i.e. a so-called bipolar gate being highly doped, which however is not that advantageous, since it will then take current.

"Substrate layer" is in this disclosure to be interpreted as the layer closest to the drain of the layers mentioned and it has not to be a substrate layer in the strict sense of this word within this field, i.e. the layer from which the growth is started. The real substrate layer may be any of the layers and is mostly the thickest one, which may be the drift layer.

The method claim is to be interpreted as not restricted to a growth of the layers located on top of each other in the order they are mentioned, but any other order of growth of these layers is within the scope of the claims. For instance, the method may be started from the drift layer and the so called substrate layer and the drain may be grown at the very end of the method.

The scope of the invention is defined solely by the appended claims.

## Claims

1. A field controlled semiconductor device of SiC comprising superimposed in the order mentioned at least a drain (12), a highly doped substrate layer (1) and a low doped n-type drift layer (2), said device further comprising a highly doped n-type source region layer (6) and a source (11) connected thereto, a doped channel region layer (4) connecting said source region layer to said drift layer and through which a current is intended to flow when the device is in an on-state, and a gate electrode (9) arranged to, upon applying a voltage thereto, influence the charge carrier distribution of said channel region layer and by that the conductivity thereof, said channel region layer having a substantially lateral extension and being formed by a low doped n-type layer, the device further comprising a p-type base layer (3) formed in a surface layer of said drift layer (2) and arranged under the low doped n-type channel region layer (4) on the opposite side thereof with respect to the gate electrode (9) for forming a n-type conducting channel in the channel region layer at a distance from an upper surface of said channel region layer, said gate electrode being arranged to influence said channel region from above for giving a conducting channel created therein from the source region layer to the drift layer a substantially lateral extension, **characterised in that** said channel region layer (4) comprises a wall (5) extending to the drift layer, an additional highly doped n-type layer (7) being formed in said wall (5) and in a surface layer of said drift layer (2), said highly doped n-type layer (7) being arranged to connect said low doped n-type channel region layer (4) to the drift layer (2), **in that** the source region layer (6) and said additional n-type layer (7) are arranged at a mutual lateral distance leaving a part of said channel region layer exposed to a voltage of said gate electrode (9) therebetween, and **in that** said source region layer (6) is arranged on top of portions of the channel region layer (4) vertically separating the source region layer (6) from the base layer (3).

2. A device according to claim 1, **characterized in that** said p-type base layer (3) is highly doped.

3. A device according to claim 1 or 2, **characterized in that** said gate electrode (9) is insulated with respect to the channel region layer by an interposed insulating layer (8).

4. A device according to claim 1 or 2, **characterized in that** the thickness and doping concentration of the low doped channel region layer (4) are co-ordinated with the doping concentration of said base layer (3) and the choice of the gate so as to form a p-type depletion region (16) in the channel region layer totally blocking the passage of electrons from said source region layer to the drift layer when a zero potential is laid on the gate electrode for making the device a normally-off device.

5. A device according to claim 1 or 2 and 3, **characterized in that** it is a MISFET having a highly doped n-type substrate layer (1), that said low doped n-type channel region layer is a part of the drift layer (2) extending laterally in between the insulating layer and said base layer (3), which is buried in the drift layer, for forming, upon applying a voltage to said gate electrode, a conducting channel (17) from the source region layer (6) to the drift layer (2) at the interface between the base layer and said channel region layer at a distance from said insulating layer (8).

6. A device according to any of claims 1-4, **characterized in that** it has a highly doped n-type substrate layer (1) and is a transistor.

7. A device according to any of claims 1-4, **characterized in that** it is a thyristor and that it has a highly doped p-type substrate layer (1) and one of a) a highly doped n-type buffer layer and b) no such layer between said substrate layer and the drift layer.

8. A method for producing a field controlled semiconductor device of SiC being one of a) a transistor and b) a thyristor, comprising the steps of:
1) epitaxially growing on top of each other the following semiconductor layers of SiC: a highly doped substrate layer (1) being for a) of n-type and for b) of p-type and a low doped n-type drift layer (2),
2) implanting p-type dopants into a surface layer of said drift layer for forming a p-type base layer (3),
3) epitaxially growing a low doped n-type channel region layer (4) on top of said base layer,
4) etching away said channel region layer for forming a wall (5) extending to the drift layer,
5) implanting n-type dopants into a surface layer of said channel region laye (4) for forming a highly doped n-type source region layer (6) vertically separated from said base layer (3) by portions of the channel region layer (4),
6) implanting n-type dopants into said channel region layer (4) at a lateral distance from said source region layer (6) and in connection with said wall and into said wall (5) for forming an additional n-type layer (7) extending from said channel region layer to the drift layer,
7) applying a gate electrode (9) on said channel region layer between the source region layer and said additional n-type layer and a source (11) on said source region layer,
the steps 4) and 5) being carried out in one of the following orders: a) 4) and then 5) and b) 5) and then 4).

9. A method according to claim 8, **characterized in that** step 4) is carried out before step 5) and steps 5) and 6) are carried out at the same time as one single process step.

## Patentansprüche

1. Feldgesteuertes Halbleiterbauelement aus SiC, das in der erwähnten Reihenfolge übereinander gelegt Folgendes umfasst: wenigstens einen Drain (12), eine hoch dotierte Substratschicht (1) und eine niedrig dotierte Drift-Schicht (2) des n-Typs, wobei das genannte Bauelement ferner Folgendes umfasst: eine hoch dotierte Source-Zonenschicht (6) des n-Typs und eine damit verbundene Source (11), eine dotierte Kanalzonenschicht (4), die die genannte Source-Zonenschicht mit der genannten Drift-Schicht verbindet und durch die ein Strom geleitet werden soll, wenn das Bauelement im Einschaltzustand ist, und eine Gate-Elektrode (9) mit der Aufgabe, nach dem Anlegen einer Spannung daran die Ladungsträgerverteilung der genannten Kanalzonenschicht und dadurch deren Leitfähigkeit zu beeinflussen, wobei die genannte Kanalzonenschicht eine im Wesentlichen laterale Verlängerung hat und durch eine niedrig dotierte Schicht des n-Typs gebildet wird, wobei das Bauelement ferner eine Basisschicht (3) des p-Typs umfasst, die in einer Oberflächenschicht der genannten Drift-Schicht (2) ausgebildet und unter der niedrig dotierten Kanalzonenschicht (4) des n-Typs auf der gegenüberliegenden Seite davon mit Bezug auf die Gate-Elektrode (9) angeordnet ist, um einen leitenden Kanal des n-Typs in der Kanalzonenschicht in einem Abstand von einer Oberseite der genannten Kanalzonenschicht zu bilden, wobei die genannte Gate-Elektrode so ausgelegt ist, dass sie die genannte Kanalzone von oben beeinflusst, um einem darin von der Source-Zonenschicht zur Drift-Schicht erzeugten leitenden Kanal eine im Wesentlichen laterale Verlängerung zu geben, **dadurch gekennzeichnet, dass** die genannte Kanalzonenschicht (4) eine zur Drift-Schicht verlaufende Wand (5) umfasst, wobei eine zusätzliche hoch dotierte Schicht (7) des n-Typs in der genannten Wand (5) und in einer Oberflächenschicht der genannten Drift-Schicht (2) ausgebildet ist, wobei die genannte hoch dotierte Schicht (7) des n-Typs so angeordnet ist, dass sie die genannte niedrig dotierte Kanalzonenschicht (4) des n-Typs mit der Drift-Schicht (2) verbindet, dadurch, dass die Source-Zonenschicht (6) und die genannte zusätzliche Schicht (7) des n-Typs in einem gegenseitigen lateralen Abstand angeordnet sind, so dass ein Teil der genannten Kanalzonenschicht einer Spannung der genannten Gate-Elektrode (9) dazwischen ausgesetzt bleibt, und dadurch, dass die genannte Source-Zonenschicht (6) auf Teilen der Kanalzonenschicht (4) angeordnet ist und die Source-Zonenschicht (6) von der Basisschicht (3) vertikal trennt.

2. Bauelement nach Anspruch 1, **dadurch gekennzeichnet, dass** die genannte Basisschicht (3) des p-Typs hoch dotiert ist.

3. Bauelement nach Anspruch 1 oder 2, **dadurch gekennzeichnet, dass** die genannte Gate-Elektrode (9) in Bezug auf die Kanalzonenschicht durch eine dazwischen liegende Isolierschicht (8) isoliert wird.

4. Bauelement nach Anspruch 1 oder 2, **dadurch gekennzeichnet, dass** Dicke und Dotierungskonzentration der niedrig dotierten Kanalzonenschicht (4) mit der Dotierungskonzentration der genannten Basisschicht (3) und der Wahl des Gate koordiniert sind, so dass eine Verarmungszone (16) des p-Typs in der Kanalzonenschicht entsteht, die die Passage von Elektronen von der genannten Source-Zonenschicht zur Drift-Schicht völlig sperrt, wenn ein Nullpotential an die Gate-Elektrode angelegt wird, um das Bauelement zu einem normal ausgeschalteten Bauelement zu machen.

5. Bauelement nach Anspruch 1 oder 2 und 3, **dadurch gekennzeichnet, dass** es ein MISFET mit einer hoch dotierten Substratschicht (1) des n-Typs ist, wobei die genannte niedrig dotierte Kanalzonenschicht des n-Typs Teil der Drift-Schicht (2) ist, die lateral zwischen der Isolierschicht und der genannten Basisschicht (3) verläuft, die in der Drift-Schicht vergraben ist, um nach dem Anlegen einer Spannung an die genannte Gate-Elektrode einen leitenden Kanal (17) von der Source-Zonenschicht (6) zur Drift-Schicht (2) an der Grenzfläche zwischen der Basisschicht und der genannten Kanalzonenschicht in einem Abstand von der genannten Isolierschicht (8) zu bilden.

6. Bauelement nach einem der Ansprüche 1-4, **dadurch gekennzeichnet, dass** es eine hoch dotierte Substratschicht (1) des n-Typs hat und ein Transistor ist.

7. Bauelement nach einem der Ansprüche 1-4, **dadurch gekennzeichnet, dass** es ein Thyristor ist und dass es eine hoch dotierte Substratschicht (1) des p-Typs und eine a) hoch dotierte Pufferschicht des n-Typs oder b) keine solche Schicht zwischen der genannten Substratschicht und der Drift-Schicht hat.

8. Verfahren zum Erzeugen eines feldgesteuerten Halbleiterbauelements aus SiC, das ein a) Transistor oder b) ein Thyristor ist, umfassend die folgenden Schritte:
1) epitaktisches Aufwachsenlassen der folgenden Halbleiterschichten aus SiC übereinander: eine hoch dotierte Substratschicht (1), die für a) vom n-Typ und für b) vom p-Typ ist, und eine niedrig dotierte Drift-Schicht (2) des n-Typs,
2) Implantieren von Dotierungsmitteln des p-Typs in eine Oberflächenschicht der genannten Drift-Schicht zum Bilden einer Basisschicht (3) des p-Typs,
3) epitaktisches Aufwachsenlassen einer niedrig dotierten Kanalzonenschicht (4) des n-Typs auf der genannten Basisschicht,
4) Wegätzen der genannten Kanalzonenschicht zum Formen einer zur Drift-Schicht verlaufenden Wand (5);
5) Implantieren von Dotierungsmitteln des n-Typs in eine Oberflächenschicht der genannten Kanalzonenschicht (4) zum Bilden einer hoch dotierten Source-Zonenschicht (6) des n-Typs, die durch Teile der Kanalzonenschicht (4) von der genannten Basisschicht (3) vertikal getrennt ist,
6) Implantieren von Dotierungsmitteln des n-Typs in die genannte Kanalzonenschicht (4) in einem lateralen Abstand von der genannten Source-Zonenschicht (6) und in Verbindung mit der genannten Wand und in die genannte Wand (5) zum Bilden einer zusätzlichen Schicht (7) des n-Typs, die von der genannten Kanalzonenschicht zur Drift-Schicht verläuft,
7) Aufbringen einer Gate-Elektrode (9) auf die genannte Kanalzonenschicht zwischen der Source-Zonenschicht und der genannten zusätzlichen Schicht des n-Typs und einer Source (11) auf der genannten Source-Zonenschicht,
wobei die Schritte 4) und 5) in einer der folgenden Reihenfolgen durchgeführt werden: a) 4) und dann 5) oder b) 5) und dann 4).

9. Verfahren nach Anspruch 8, **dadurch gekennzeichnet, dass** Schritt 4) vor Schritt 5) durchgeführt wird und die Schritte 5) und 6) gleichzeitig als ein einzelner Prozessschritt durchgeführt werden.

## Revendications

1. Dispositif semi-conducteur commandé par champ de SiC comprenant superposés dans l'ordre indiqué au moins un drain (12), une couche de substrat fortement dopée (1) et une couche de dérive de type n faiblement dopée (2), ledit dispositif comprenant en outre une couche de région de source de type n fortement dopée (6) et une source (11) connectée à celle-ci, une couche de région de canal dopée (4) reliant ladite couche de région de source à ladite couche de dérive et à travers laquelle un courant est destiné à s'écouler quand le dispositif se trouve dans un état passant, et une électrode de grille (9) agencée pour, à l'application d'une tension à celle-ci, influencer la distribution des porteurs de charge de ladite couche de région de canal et par là la conductivité de celle-ci, ladite couche de région de canal source ayant une extension sensiblement latérale et étant formée par une couche de type n faiblement dopée, le dispositif comprenant en outre une couche de base de type p (3) formée dans une couche de surface de ladite couche de dérive (2) et agencée sous la couche de région de canal de type n faiblement dopée (4) sur le côté opposé de celle-ci relativement à l'électrode de grille (9) pour former un canal conducteur de type n dans la couche de région de canal à une certaine distance d'une surface supérieure de ladite couche de région de canal, ladite électrode de grille étant agencée pour influencer ladite région de canal par le dessus pour donner à un canal conducteur créé dans celle-ci depuis la couche de région de source jusqu'à la couche de dérive une extension sensiblement latérale, **caractérisé en ce que** ladite couche de région de canal (4) comprend une paroi (5) qui s'étend jusqu'à la couche de dérive, une couche de type n fortement dopée supplémentaire (7) étant formée dans ladite paroi (5) et dans une couche de surface de ladite couche de dérive (2), ladite couche de type n fortement dopée (7) étant agencée pour connecter ladite couche de région de canal de type n faiblement dopée (4) à la couche de dérive (2), **en ce que** la couche de région de source (6) et ladite couche de type n supplémentaire (7) sont agencées à une distance latérale mutuelle laissant une partie de ladite couche de région de canal exposée à une tension de ladite électrode de grille (9) entre elles, et **en ce que** ladite couche de région de source (6) est agencée au-dessus de parties de la couche de région de canal (4) séparant verticalement la couche de région de source (6) de la couche de base (3).

2. Dispositif selon la revendication 1, **caractérisé en ce que** ladite couche de base de type p (3) est fortement dopée.

3. Dispositif selon la revendication 1 ou 2, **caractérisé en ce que** ladite électrode de grille (9) est isolée par rapport à la couche de région de canal par une couche isolante interposée (8).

4. Dispositif selon la revendication 1 ou 2, **caractérisé en ce que** l'épaisseur et la concentration de dopage de la couche de région de canal faiblement dopée (4) sont coordonnées à la concentration de dopage de ladite couche de base (3) et au choix de la grille de façon à former une région d'appauvrissement de type p (16) dans la couche de région de canal qui bloque totalement le passage d'électrons depuis ladite couche de région de source vers la couche de dérive quand un potentiel nul est appliqué à l'électrode de grille pour faire du dispositif un dispositif normalement bloquant.

5. Dispositif selon la revendication 1 ou 2 et 3, **caractérisé en ce qu'**il s'agit d'un MISFET ayant une couche de substrat de type n fortement dopée (1), **en ce que** ladite couche de région de canal de type n faiblement dopée fait partie de la couche de dérive (2) s'étendant latéralement entre la couche isolante et ladite couche de base (3), laquelle est noyée dans la couche de dérive, afin de former, à l'application d'une tension sur ladite électrode de grille, un canal conducteur (17) depuis la couche de région de source (6) jusqu'à la couche de dérive (2) au niveau de l'interface entre la couche de base et ladite couche de région de canal à une certaine distance de ladite couche isolante (8).

6. Dispositif selon l'une quelconque des revendications 1 à 4, **caractérisé en ce qu'**il comporte une couche de substrat de type n fortement dopée (1) et consiste en un transistor.

7. Dispositif selon l'une quelconque des revendications 1 à 4, **caractérisé en ce qu'**il s'agit d'un thyristor et qu'il comporte une couche de substrat de type p fortement dopée (1) et a) une couche tampon de type n fortement dopée ou b) aucune telle couche entre ladite couche de substrat et la couche de dérive.

8. Procédé de production d'un dispositif semi-conducteur commandé par champ de SiC étant l'un a) d'un transistor et b) d'un thyristor, comprenant les étapes suivantes :
1) la croissance épitaxiale les unes au-dessus des autres des couches semi-conductrices suivantes de SiC : une couche de substrat fortement dopée (1) pour a) du type n et pour b) du type p et une couche de dérive de type n faiblement dopée (2),
2) l'implantation de dopants de type p dans une couche de surface de ladite couche de dérive pour former une couche de base de type p (3),
3) la croissance épitaxiale d'une couche de région de canal de type n faiblement dopée (4) au-dessus de ladite couche de base,
4) l'élimination par gravure de ladite couche de région de canal pour former une paroi (5) s'étendant jusqu'à la couche de dérive,
5) l'implantation de dopants de type n dans une couche de surface de ladite couche de région de canal (4) ou formation d'une couche de région de source de type n fortement dopée (6) séparée verticalement de ladite couche de base (3) par des parties de la couche de région de canal (4),
6) l'implantation de dopants de type n dans ladite couche de région de canal (4) à une distance latérale de ladite couche de région de source (6) et relativement à ladite paroi et à l'intérieur de ladite paroi (5) pour former une couche de type n supplémentaire (7) s'étendant depuis ladite couche de région de canal jusqu'à la couche de dérive,
7) l'application d'une électrode de grille (9) sur ladite couche de région de canal entre la couche de région de source et ladite couche de type n supplémentaire et une source (11) sur ladite couche de région de source,
les étapes 4) et 5) étant exécutées dans l'un des ordres suivants : a) 4) puis 5) et b) 5) puis 4).

9. Procédé selon la revendication 8, **caractérisé en ce que** l'étape 4) est exécutée avant l'étape 5 et les étapes 5) et 6) sont exécutées simultanément comme étape de traitement unique.
